# EUROPEAN PATENT APPLICATION

(11) **EP 4 507 469 A1**
(43) Date of publication of application: **12.02.2025**
(21) Application number: 24751361.7
(22) Date of filing: 10.06.2024
(51) Int. Cl.: H05K 9/00, C09K 5/14, H05K 1/02, C09K 5/10, H05K 1/11

(54) **PRINTED CIRCUIT BOARD STRUCTURE COMPRISING THERMAL INTERFACE MATERIAL AND ELECTRONIC DEVICE COMPRISING SAME**

(30) Priority: 23.06.2023 KR 20230081428; 21.07.2023 KR 20230095382
(71) Applicant: Samsung Electronics Co., Ltd, Suwon-si, Gyeonggi-do 16677 (KR)
(72) Inventor: KIM, Jongyeon, Suwon-si, Gyeonggi-do 16677 (KR); KIM, Minsoo, Suwon-si, Gyeonggi-do 16677 (KR); KIM, Yongwoon, Suwon-si, Gyeonggi-do 16677 (KR); PARK, Eunsoo, Suwon-si, Gyeonggi-do 16677 (KR)
(74) Representative: Appleyard Lees IP LLP
(86) International application number: PCT/KR2024/007837
(87) International publication number: WO 2024/262851

(57) **Abstract**

A printed circuit board (PCB) (200) may include a first PCB (210); an interposer (230); a second PCB (220); a shield structure (240); and a guide (250) disposed on the first PCB and configured to guide at least a portion of a thermal interface material (TIM) that fills a first inner space (S1) to a second inner space (S2).

## Description

### BACKGROUND

### 1. Field

The present disclosure relates to a printed circuit board (PCB) structure and an electronic device, for example, a PCB structure for accommodating a thermal interface material and an electronic device including the same.

### 2. Description of Related Art

An electronic device may generate a large amount of heat due to its high performance and implementation of various functions. The heat dissipation performance of the electronic device is essential to secure product stability and reliability. Accordingly, technology for heat dissipation inside an electronic device in a limited space is being actively studied.

A technique for heat dissipation by injecting a liquid thermal interface material (TIM) into the inner space of an electronic device and hardening the TIM injected therein has been known.

### SUMMARY

According to an embodiment, in the case of an electronic device including a printed circuit board (PCB) structure for containing a thermal interface material (TIM), the PCB structure 200 may include a first PCB 210, an interposer 230 connected to the first PCB, a second PCB 220 which includes a second PCB body 221 connected to the interposer, a nozzle hole 222 formed through the second PCB body, and a guide hole 223 formed through the second PCB body and provided at a position spaced apart from the nozzle hole and which is configured to define a first inner space S1 together with the first PCB and the interposer, a shield structure 240 connected to the second PCB and configured to contain the TIM passing through the guide hole and define a second inner space S2 connected through the guide hole to the first inner space, and a guide 250 disposed on the first PCB and configured to guide at least a portion of the TIM that fills the first inner space to the second inner space.

A PCB structure for containing a TIM may include a first PCB 210, an interposer 230 connected to the first PCB, a second PCB 220 which includes a second PCB body 221 connected to the interposer, a nozzle hole 222 formed through the second PCB body, and a guide hole 223 formed through the second PCB body and provided at a position spaced apart from the nozzle hole and which is configured to define a first inner space S1 together with the first PCB and the interposer, a shield structure 240 connected to the second PCB and configured to contain the TIM passing through the guide hole and define a second inner space S2 connected through the guide hole to the first inner space, and a guide 250 disposed on the first PCB and configured to guide at least a portion of the TIM that fills the first inner space to the second inner space.

According to an embodiment, in the case of an electronic device including a PCB structure for containing a TIM, the PCB structure 200 may include a first PCB 210, an interposer 230 connected to the first PCB, a second PCB 220 which includes a second PCB body 221 connected to the interposer, a nozzle hole 222 formed through the second PCB body, a guide hole 223 formed through the second PCB body and provided at a position spaced apart from the nozzle hole, and a vent hole 224 formed through the second PCB body and which is configured to define a first inner space S1 together with the first PCB and the interposer, a shield structure 240 connected to the second PCB and configured to contain the TIM passing through the guide hole and define a second inner space S2 connected through the guide hole to the first inner space, and a guide 250 disposed on the first PCB, configured to guide at least a portion of the TIM that fills the first inner space to the second inner space and to overlap the shield structure based on a stacking direction of the first PCB, the interposer, and the second PCB, and provided in a state of contacting the second PCB, wherein the vent hole 224 may be positioned opposite the nozzle hole 222 based on the guide 250.

### BRIEF DESCRIPTION OF THE DRAWINGS

The above and other aspects, features, and advantages of certain embodiments of the present disclosure will be more apparent from the following detailed description, taken in conjunction with the accompanying drawings, in which:
FIG. 1 is a block diagram illustrating an electronic device in a network environment;
FIG. 2 is a perspective view of a printed circuit board (PCB) structure for containing a thermal interface material (TIM);
FIG. 3 is a cross-sectional view taken along a line III-III of FIG. 2;
FIG. 4 is a cross-sectional view schematically illustrating an process of injecting a TIM into a PCB structure;
FIG. 5 is an exploded perspective view illustrating a PCB structure;
FIG. 6 is a plan view schematically illustrating the inside of a PCB structure;
FIG. 7 is a plan view schematically illustrating the inside of a PCB structure;
FIG. 8 is a plan view schematically illustrating the inside of a PCB structure;
FIG. 9 is a plan view schematically illustrating the inside of a PCB structure; and
FIG. 10 is a plan view schematically illustrating the inside of a PCB structure.

### DETAILED DESCRIPTION

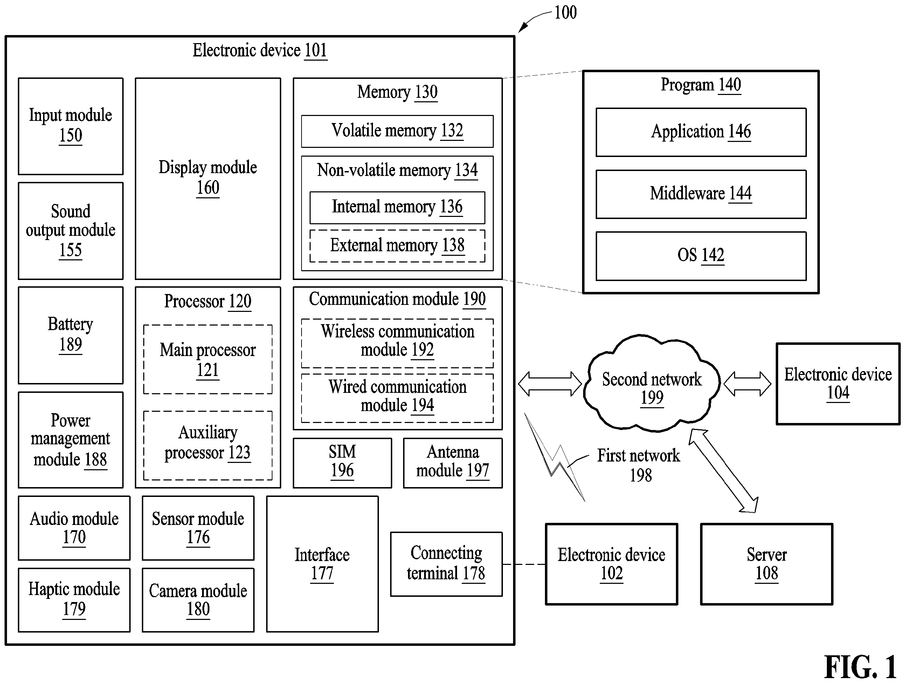

FIG. 1 is a block diagram illustrating an electronic device in a network environment.

Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). The electronic device 101 may communicate with the electronic device 104 via the server 108. The electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. At least one of the components (e.g., the connecting terminal 178) may be omitted from the electronic device 101, or one or more other components may be added in the electronic device 101. Some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. The processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). The auxiliary processor 123 (e.g., an image signal processor or a communication processor) may be implemented as part of another component (e.g., the camera module 180 or the communication module 190) functionally related to the auxiliary processor 123. The auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed, or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network, or a combination of two or more thereof, but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include a touch sensor adapted to detect a touch, or a pressure sensor adapted to measure the intensity of force incurred by the touch.

The audio module 170 may convert a sound into an electrical signal and vice versa. The audio module 170 may obtain the sound via the input module 150 or output the sound via the sound output module 155 or an external electronic device (e.g., an electronic device 102 such as a speaker or a headphone) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. The interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected with the external electronic device (e.g., the electronic device 102). The connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image and moving images. The camera module 180 may include one or more lenses, image sensors, image signal processors, or flashes.

The power management module 188 may manage power supplied to the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor) and support direct (e.g., wired) communication or wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). The wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may be transmitted or received between the communication module 190 and the external electronic device via the selected at least one antenna. Another component (e.g., a radio frequency integrated circuit (RFIC)) other than the radiating element may be additionally formed as part of the antenna module 197.

The antenna module 197 may form a mmWave antenna module. The mmWave antenna module may include a PCB, a RFIC disposed on a first surface (e.g., the bottom surface) of the PCB or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 and 104 may be a device of a same type as, or a different type from, the electronic device 101. All or some of operations to be executed at the electronic device 101 may be executed at one or more of the external electronic devices (e.g., the external devices 102 and 104, and the server 108). For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. The external electronic device 104 may include an Internet-of-things (IoT) device. The server 108 may be an intelligent server using machine learning and/or a neural network. The external electronic device 104 or the server 108 may be included in the second network 199. The electronic device 101 may be applied to intelligent services (e.g., smart home, smart city, smart car, or healthcare) based on 5G communication technology or IoT-related technology.

The electronic device may be one of various types of electronic devices. The electronic devices may include, for example, a portable communication device (e.g., a smart phone), a computer device, a portable multimedia device, a portable medical device, a camera, a wearable device, or a home appliance. The electronic devices are not limited to those described above.

It should be appreciated that embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms such as "1^{st}," and "2^{nd}," or "first" and "second" may be used to simply distinguish a corresponding component from another, and do not limit the components in other aspect (e.g., importance or order). It is to be understood that if a component (e.g., a first component) is referred to, with or without the term "operatively" or "communicatively," as "coupled with," "coupled to," "connected with," or "connected to" another component (e.g., a second component), the component may be coupled with the other component directly (e.g., wiredly), wirelessly, or via a third component.

The term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, The module may be implemented in a form of an application-specific integrated circuit (ASIC).

Embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities, and some of the multiple entities may be separately disposed in different components. One or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

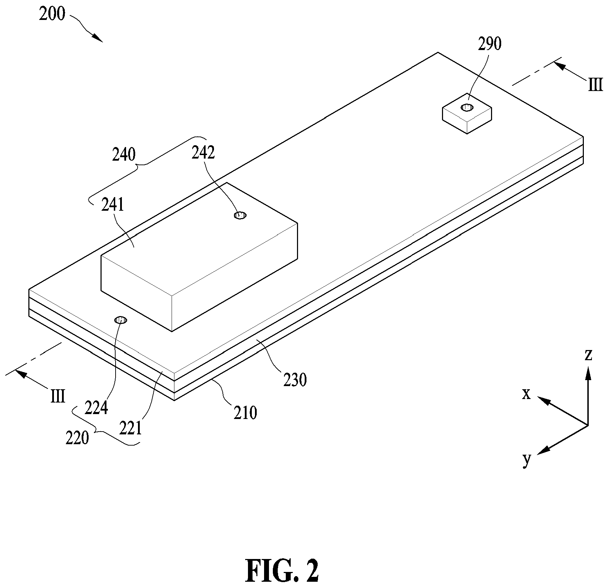

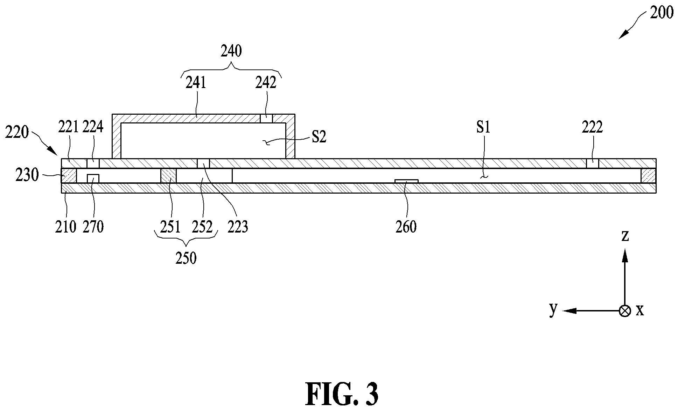

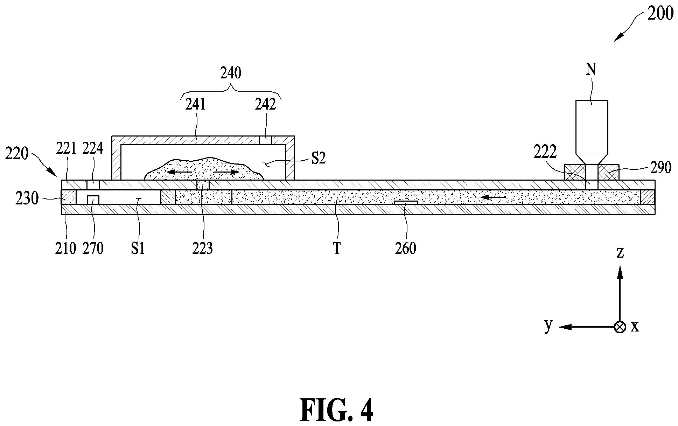

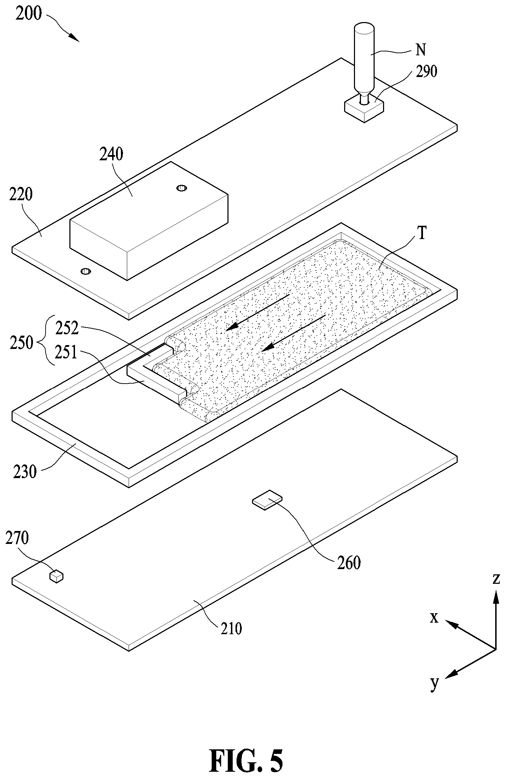

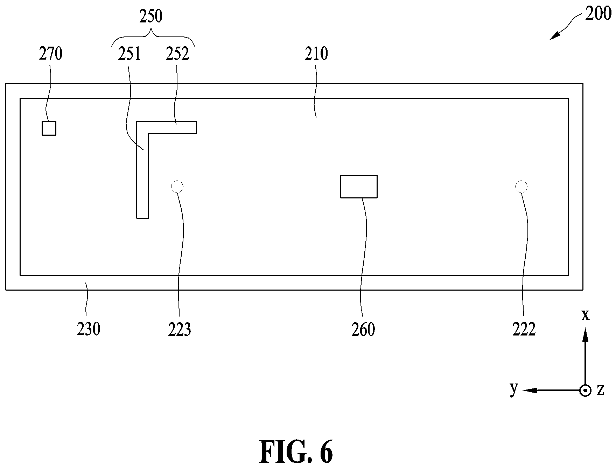

FIG. 2 is a perspective view of a printed circuit board (PCB) structure for containing a thermal interface material (TIM). FIG. 3 is a cross-sectional view taken along a line III-III of FIG. 2. FIG. 4 is a cross-sectional view schematically illustrating an process of injecting the TIM into the PCB structure. FIG. 5 is an exploded perspective view illustrating the PCB structure. FIG. 6 is a plan view schematically illustrating the inside of the PCB structure.

The PCB structure 200 of FIGS. 2 to 6, may be provided in an electronic device (e.g., the electronic device 101 of FIG. 1). For example, at least one of a processor (e.g., the processor 120 of FIG. 1), an input module (e.g., the input module 150 of FIG. 1), a sound output module (e.g., the sound output module 155 of FIG. 1), a display module (e.g., the display module 160 of FIG. 1), an audio module (e.g., the audio module 170 of FIG. 1), a sensor module (e.g., the sensor module 176 of FIG. 1), a haptic module (e.g., the haptic module 179 of FIG. 1), a camera module (e.g., the camera module 180 of FIG. 1), a power management module (e.g., the power management module 188 of FIG. 1), a communication module (e.g., the communication module 190 of FIG. 1), a subscriber identification module (e.g., the subscriber identification module 196 of FIG. 1), or an antenna module (e.g., the antenna module 197 of FIG. 1) of the electronic device (e.g., the electronic device 101 of FIG. 1) may include the PCB structure 200.

The PCB structure 200 may contain a TIM T, as shown in FIG. 4. The TIM T may be injected into the PCB structure 200. The TIM T may be injected into the PCB structure 200 in a liquid state and then hardened. The TIM T assists in better (e.g., more efficient, faster, etc.) transfer of heat within the PCB structure 200.

The PCB structure 200 may include a plurality of components that require cooling. For example, the PCB structure 200 may include an application processor (AP) or a power amplifier (PA). Such components generate heat and thus, may be referred to as thermal sources. For the normal operation of these components, sufficient cooling is required. The TIM T that fills the PCB structure 200 may absorb heat from the thermal sources and spread the heat over a large area, thus increasing the efficiency of heat dissipation.

The PCB structure 200 may include components that do not generate heat and/or are heat-sensitive. For example, the PCB structure 200 may include at least one of a crystal or an oscillator. If excessive heat is applied to the crystal or oscillator, the performance of the crystal or oscillator may decrease, i.e., they are heat-sensitive. The PCB structure 200 may assist, through a guide 250, the TIM T to be sufficiently applied to the thermal sources and to reach in a relatively small amount or not to reach the heat-sensitive components. The guide 250 may guide the traveling direction of the TIM T. The guide 250 may guide the flow of the TIM T.

The PCB structure 200 may include a plurality of inner spaces S1 and S2 that are partially partitioned from each other, such that the second inner space S2 may be connected to the first inner space S1 through the guide hole 223. The guide 250 may guide the traveling direction of the TIM T and assist the TIM T to move from the first inner space S1 to the second inner space S2. Although a single guide 250 is shown in the drawings, the number of guides 250 is not limited thereto. For example, depending on the number and arrangement of second components, a plurality of guides 250 may be provided.

The PCB structure 200 may include a first PCB 210, a second PCB 220, an interposer 230, a shield structure 240, a guide 250, a first component 260, a second component 270, and a nozzle block 290. The first PCB 210, the second PCB 220, and the interposer 230 may define the first inner space S 1. The first inner space S1 may be a space surrounded by the first PCB 210, the second PCB 220, and the interposer 230. For example, the first inner space S1 may be defined by the first PCB 210 at the top, the second PCB 220 at the bottom, and the interposer 230 around the sides. Components may be disposed in the first inner space S1. For example, a thermal source may be disposed in the first inner space S1. The shield structure 240 may define the second inner space S2. The second inner space S2 may be a space surrounded by the shield structure 240. The shield structure 240 may include a shield can or a stacked PCB structure. The stacked PCB structure may include a plurality of PCBs and an interposer provided between two adjacent PCBs among the plurality of PCBs. Components may also be disposed in the second inner space S2. For example, a thermal source may be disposed in the second inner space S2.

The first PCB 210 may be a PCB including a rigid material. The first PCB 210 may be a flexible printed circuit board (FPCB) including a flexible material. The first PCB 210 may have a flat plate shape. The shape of the first PCB 210 is shown as a rectangular parallelepiped, but is not limited thereto.

The second PCB 220 may be provided at a position spaced apart from the first PCB 210. Referring to FIGS. 2 to 6, the second PCB 220 is spaced apart from the first PCB 210 in the z-axis direction. As shown in FIGS. 2 to 6, the stacking direction of the first PCB 210, the interposer 230, and the second PCB 220 is parallel to the z-axis direction. The second PCB 220 may include a second PCB body 221, a nozzle hole 222, a guide hole 223, and a vent hole 224.

The second PCB 220 may be a PCB including a rigid material. For example, the second PCB 220 may be an FPCB including a flexible material. The second PCB body 221 may have a flat plate shape.

The nozzle hole 222 may be formed through the second PCB body 221. Through the nozzle hole 222, the TIM T may be injected into the first inner space S 1. The TIM T injected into the first inner space S1 may travel in the x-axis direction and/or the y-axis direction.

The guide hole 223 may be formed through the second PCB body 221. The TIM T injected into the first inner space S1 may travel through the first inner space S1 from the nozzle hole 222 to the guide hole 223. As the TIM T flows through the first inner space S1, the guide 250 may change the traveling path of the TIM T. The TIM T may enter the guide hole 223 as its traveling path is changed by the guide 250. The TIM T passing through the guide hole 223 thus may be injected into the second inner space S2. The PCB structure 200 may be configured to allow simultaneous injection of the TIM T into the first inner space S1 and the second inner space S2 when the TIM T is injected through the nozzle hole 222 provided in the second PCB 220.

The vent hole 224 may be formed through the second PCB body 221. The vent hole 224 may be provided at a position spaced apart from the shield structure 240. The vent hole 224 and the nozzle hole 222 may be positioned on opposite sides of the shield structure. The TIM T injected through the nozzle hole 222 may pass through the guide hole 223 and be injected into the second inner space S2, without reaching the vent hole 224. The vent hole 224 improves injection of TIM T into the first inner space S1, for example, as the first inner space S1 is filled with the TIM T, air is discharged from inside the first inner space S1 via the vent hole 224 to the outside.

The interposer 230 may be disposed between the first PCB 210 and the second PCB 220. The interposer 230 may be connected to the first PCB 210. The interposer 230 may be connected to the second PCB 220. The interposer 230 may electrically connect the components disposed on the first PCB 210 and the components disposed on the second PCB 220.

The shield structure 240 may be connected to the second PCB 220. The shield structure 240 may be configured to contain the TIM T passing through the guide hole 223. The shield structure 240 may define the second inner space S2. The second inner space S2 may be connected to the first inner space S1 through the guide hole 223. The shield structure 240 may include a shield structure body 241 that defines the second inner space S2, and an air hole 242 formed through the shield structure body 241. The air hole 242 may connect the second inner space S2 to the outside, thereby improving the injection of the TIM T into the second inner space S2. Specifically, when the TIM T is injected into the second inner space S2, air is discharged from the second inner space S2 via the air hole 242 to the outside. To prevent increased air pressure in the second inner space S2 during injection, the volume of air discharged therefrom should be the same as, or comparable to, the volume of the second inner space S2occupied by the TIM T. The air hole 242 may function as a passage for the air to be discharged.

The guide 250 may be disposed on the first PCB 210. The guide 250 may guide at least a portion of the TIM T from the first inner space S1 to the second inner space S2. The guide 250 may be disposed on the traveling path of the TIM T and thus may change the traveling path of the TIM T. For example, the TIM T may flow in the xy plane before contacting the guide 250, and may flow in the z-axis direction and pass through the guide hole 223 after contacting the guide 250. The guide 250 may partially block the path of the TIM T.

The guide 250 may be provided at a position adjacent to the guide hole 223. The guide 250 may at least partially overlap the shield structure 240 when viewed along the stacking direction of the first PCB 210, the interposer 230, and the second PCB 220. In effect, the guide 250 may at least partially overlap the shield structure 240 when viewed along the z-axis direction. The guide 250 may not overlap the guide hole 223 when viewed along the z-axis direction. The guide 250 and the nozzle hole 222 may be positioned on opposite sides of the guide hole 223. The TIM T flowing toward the guide 250 may pass by or through the guide hole 223. If the guide 250 is not provided, the TIM T flows along one surface of the first PCB 210 due to gravity, and may not pass through the guide hole 223, instead passing by the guide hole 223. The guide 250 may partially or completely block the flow of the TIM T on the xy plane, thereby causing the TIM T to flow in the z-axis direction.

The guide 250 may include a first part 251 and a second part 252. The first part 251 may have an elongated shape, with a longitudinal direction corresponding to a first direction. Here, the first direction may be a direction parallel to the x-axis direction. The first part 251 may block a portion of the TIM T flowing in the y-axis direction. The first part 251 may guide or divert the portion of the TIM T originally flowing in the y-axis direction to the second inner space S2 via the guide hole 223, by causing the portion of the TIM T to flow partially in the x-axis direction. The first part 251 may overlap the shield structure 240 when viewed along the z-axis direction. The first part 251 may be provided at a position adjacent to the guide hole 223.

The second part 252 may have an elongated shape, with a longitudinal direction corresponding to a second direction. Here, the second direction may be parallel to the y-axis direction. The second part 252 may block a portion of the TIM T flowing in the x-axis direction. The second part 252 may guide or divert the portion of the TIM T originally flowing in the x-axis direction to the second inner space S2 via the guide hole 223, by causing the portion of the TIM T to flow partially in the y-axis direction. The second part 252 may overlap the shield structure 240 when viewed along the z-axis direction. The second part 252 may be provided at a position adjacent to the guide hole 223.

The guide 250 may include an elastic material. For example, the guide 250 may include a rubber material. For example, the guide 250 may be compressed by the first PCB 210 and the second PCB 220. In this way, gap(s) between the guide 250 and the first PCB 210 and/or the second PCB 220 may be eliminated. The guide 250 may be made from an elastic material.

The guide 250 may have the same height as the interposer 230. The guide 250 may contact the second PCB 220. Thus, there may be no gap between the guide 250 and the second PCB 220 and the TIM T may be prevented from passing over the guide 250. In another example, a fine/narrow gap may be present between the guide 250 and the second PCB 220. In this case, the TIM T may be prevented from passing over the guide 250 if the gap is sufficiently fine/narrow.

The first component 260 may be disposed on the first PCB 210. The first component 260 may be positioned in an area between the nozzle hole 222 and the guide 250 in the first inner space S1. The first component 260 may include a thermal source. For example, the first component 260 may include an application processor (AP), a radio frequency integrated circuit (RFIC), or a power amplifier (PA). The TIM T may be applied to the first component 260, i.e., the first component 260 may be positioned in an area configured to be filled with the TIM T.

The second component 270 may be disposed on the first PCB 210. The second component 270 may be positioned in the first inner space S1, in an area on the opposite side of the guide 250 to the nozzle hole 222. The second component 270 may include a component that is relatively sensitive to heat, i.e., heat-sensitive. The second component 270 may include a component that does not generate heat. The second component 270 may include a crystal and/or an oscillator. The TIM T may not be applied to the second component 270, i.e., the second component 270 may be positioned in an area that is configured not to be filled with the TIM T.

The guide 250 may assist the TIM T in not reaching the area where the second component 270 is positioned, i.e., the guide 250 may prevent the TIM T from reaching the second component 270. The guide 250 may change the traveling direction of the TIM T so that the TIM T may flow into the second inner space S2 through the guide hole 223 without reaching the second component 270.

The nozzle block 290 may be disposed on the second PCB 220. The nozzle block 290 may stabilize a nozzle N to further improve injection of the TIM T into the PCB structure 200. The nozzle block 290 may have a hole to accommodate a portion of the nozzle N. The hole of the nozzle block 290 may be fluidly connected to the nozzle hole 222.

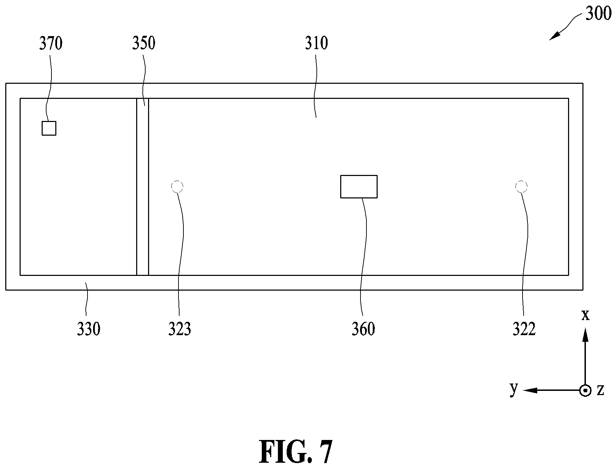

FIG. 7 is a plan view schematically illustrating the inside of a PCB structure.

Referring to FIG. 7, a PCB structure 300 is shown with a second PCB (e.g., the second PCB 220 of FIG. 2) and a shield structure (e.g., the shield structure 240 of FIG. 2) omitted. In FIG. 7, the position at which a nozzle hole 322 and a guide hole 323 would be located, if the second PCB was not omitted, are schematically depicted.

The PCB structure 300 may include a first PCB 310, a second PCB (not shown), an interposer 330, a shield structure (not shown), a guide 350, a first component 360, and a second component 370.

The first PCB 310 may be a PCB including a rigid material. The first PCB 310 may be an FPCB including a flexible material. The first PCB 310 may have a flat plate shape.

The interposer 330 may be connected to the first PCB 310.

The second PCB (not shown) may be connected to the interposer 330. The second PCB may include the nozzle hole 322 and the guide hole 323. A TIM may be injected onto the first PCB 310 through the nozzle hole 322. A TIM may be injected into the first space defined by the first PCB 310, the second PCB and the interposer 330.

The first component 360 may include a thermal source. The second component 370 may include a component that is relatively sensitive to heat and/or does not generate heat.

The guide 350 may be disposed on the first PCB 310. The guide 350 may be disposed on the traveling path of the TIM and configured to change the traveling path of the TIM. For example, the TIM may flow in the xy plane before contacting the guide 350, and may flow in the z-axis direction after contacting the guide 350. The TIM flowing in the z-axis direction may pass through the guide hole 323. The guide 350 may partially block the original traveling path of the TIM, thus causing the change in the traveling path.

The guide 350 may have an elongated shape. At least one end of the guide 350 may be connected to the interposer 330. When both ends of the guide 350 are connected to the interposer 330, the first inner space is divided into two regions, both being defined by the guide 350 and the interposer 330, and the TIM T may be completely prevented from entering one of these regions. In this case, the TIM T may not move into the region that is on the other side of the guide 350 to the guide hole 323. A hole may be provided between the guide 350 and the interposer 330 through which air is configured to flow. The TIM may not pass through the hole. In this way, air can flow between the regions defined by the guide 350 and the interposer 330, thus allowing air to flow out of a vent hole that can be provided in the region into which the TIM T cannot flow.

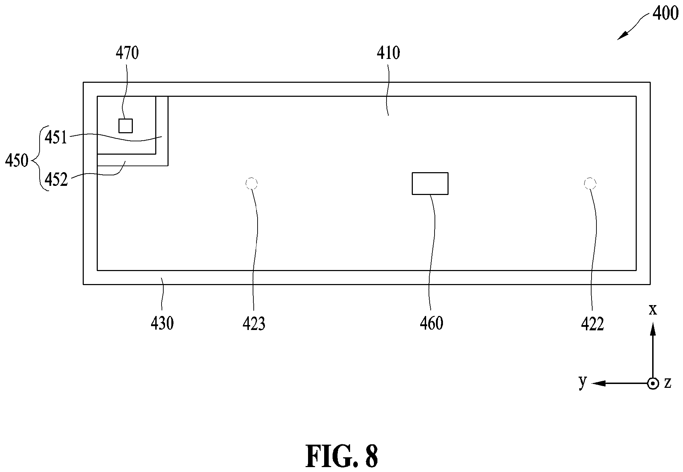

FIG. 8 is a plan view schematically illustrating the inside of a PCB structure.

Referring to FIG. 8, a PCB structure 400 is shown with a second PCB (e.g., the second PCB 220 of FIG. 2) and a shield structure (e.g., the shield structure 240 of FIG. 2) omitted. In FIG. 8, the position at which a nozzle hole 422 and a guide hole 423 would be located, if the second PCB was not omitted, are schematically depicted.

The PCB structure 400 may include a first PCB 410, a second PCB (not shown), an interposer 430, a shield structure (not shown), a guide 450, a first component 460, and a second component 470.

The first PCB 410 may include a printed circuit board.

The interposer 430 may be connected to the first PCB 410.

The second PCB (not shown) may be connected to the interposer 430. The second PCB may include the nozzle hole 422 and the guide hole 423. A TIM may be injected onto the first PCB 410 through the nozzle hole 422. A TIM may be injected into the first space defined by the first PCB 410, the second PCB and the interposer 430.

The first component 460 may include a thermal source. The second component 470 may include a component that is relatively sensitive to heat and/or does not generate heat.

The guide 450 may be disposed on the first PCB 410. The guide 450 may be disposed on the traveling path of the TIM and configured to change the traveling path of the TIM. For example, the TIM may flow in the xy plane before contacting the guide 450, and may flow in the z-axis direction after contacting the guide 450. The TIM flowing in the z-axis direction may pass through the guide hole 423. The guide 450 may partially block the original traveling path of the TIM, thus causing the change in the traveling path.

The guide 450 may include a first part 451 having an elongated shape, with a longitudinal direction corresponding to the x-axis direction. The guide 450 may also include a second part 452 having an elongated shape, with a longitudinal direction corresponding to the y-axis direction. The first part 451, the second part 452 and the interposer 430 may surround the second component 470. The first part 451 and the second part 452 may block the movement of the TIM to prevent the TIM from contacting or entering the second component 470.

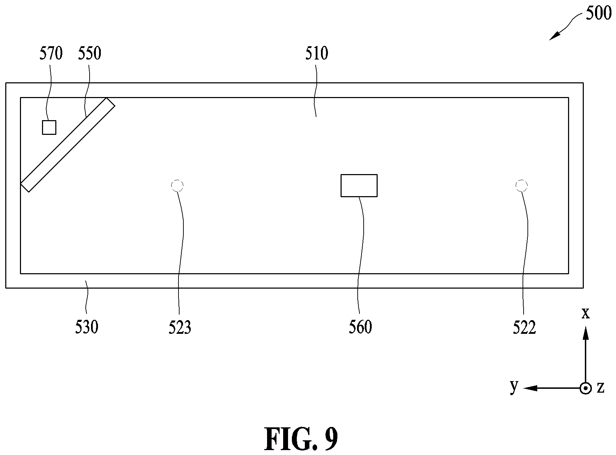

FIG. 9 is a plan view schematically illustrating the inside of a PCB structure.

Referring to FIG. 9, a PCB structure 500 is shown with a second PCB (e.g., the second PCB 220 of FIG. 2) and a shield structure (e.g., the shield structure 240 of FIG. 2) omitted. In FIG. 9, the position at which a nozzle hole 522 and a guide hole 523 would be located, if the second PCB was not omitted, are schematically depicted.

The PCB structure 500 may include a first PCB 510, a second PCB (not shown), an interposer 530, a shield structure (not shown), a guide 550, a first component 560, and a second component 570.

The first PCB 510 may include a printed circuit board.

The interposer 530 may be connected to the first PCB 510.

The second PCB (not shown) may be connected to the interposer 530. The second PCB may include the nozzle hole 522 and the guide hole 523. A TIM may be injected onto the first PCB 510 through the nozzle hole 522. A TIM may be injected into the first space defined by the first PCB 510, the second PCB and the interposer 530.

The first component 560 may include a thermal source. The second component 570 may include a component that is relatively sensitive to heat and/or does not generate heat.

The guide 550 may be disposed on the first PCB 510. The guide 550 may be disposed on the traveling path of the TIM and configured to change the traveling path of the TIM. For example, the TIM may flow in the xy plane before contacting the guide 550, and may flow in the z-axis direction after contacting the guide 550. The TIM flowing in the z-axis direction may pass through the guide hole 523. The guide 550 may partially block the original traveling path of the TIM, thus causing the change in the traveling path. The guide 550 may have an elongated shape. The longitudinal direction of the guide 550 may intersect an imaginary line representing the shortest distance between the guide hole 523 and the second component 570. One end of the guide 550 may be connected to the interposer 530. Both ends of the guide 550 may be connected to the interposer 530.

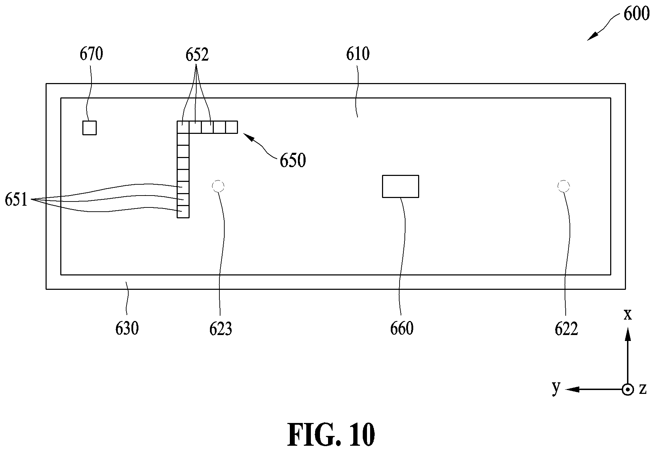

FIG. 10 is a plan view schematically illustrating the inside of a PCB structure.

Referring to FIG. 10, a PCB structure 600 is shown with a second PCB (e.g., the second PCB 220 of FIG. 2) and a shield structure (e.g., the shield structure 240 of FIG. 2) omitted. In FIG. 10, the position at which a nozzle hole 622 and a guide hole 623 would be located, if the second PCB was not omitted, are schematically depicted.

The PCB structure 600 may include a first PCB 610, a second PCB (not shown), an interposer 630, a shield structure (not shown), a guide 650, a first component 660, and a second component 670.

The first PCB 610 may include a printed circuit board.

The interposer 630 may be connected to the first PCB 610.

The second PCB (not shown) may be connected to the interposer 630. The second PCB may include the nozzle hole 622 and the guide hole 623. A TIM may be injected onto the first PCB 610 through the nozzle hole 622. A TIM may be injected into the first space defined by the first PCB 610, the second PCB and the interposer 630.

The first component 660 may include a thermal source. The second component 670 may include a component that is relatively sensitive to heat and/or does not generate heat.

The guide 650 may be disposed on the first PCB 610. The guide 650 may be disposed on the traveling path of the TIM and change the traveling path of the TIM. For example, the TIM may flow in the xy plane before contacting the guide 650, and may flow in the z-axis direction after contacting the guide 650. The TIM flowing in the z-axis direction may pass through the guide hole 623. The guide 650 may partially block the original traveling path of the TIM, thus causing the change in the traveling path.

The guide 650 may include a first part 651 having an elongated shape, with a longitudinal direction corresponding to the x-axis direction. The guide may also include a second part 652 having an elongated shape, with a longitudinal direction corresponding to the y-axis direction. The first part 651 and the second part 652 may include a plurality of unit bodies. For example, the unit bodies may be dummy elements, e.g., dummy capacitors. A separate resin may be applied to the unit bodies. The resin may be applied to the unit bodies and then cured. The resin may reduce the gap between the unit bodies and the second PCB (not shown).

In the case of an electronic device including a PCB structure for containing a TIM, the PCB structure 200 may include a first PCB 210, an interposer 230 connected to the first PCB, a second PCB 220 which includes a second PCB body 221 connected to the interposer, a nozzle hole 222 formed through the second PCB body, and a guide hole 223 formed through the second PCB body and provided at a position spaced apart from the nozzle hole and which is configured to define a first inner space S1 together with the first PCB and the interposer, a shield structure 240 connected to the second PCB and configured to contain the TIM passing through the guide hole and define a second inner space S2 connected through the guide hole to the first inner space, and a guide 250 disposed on the first PCB and configured to guide at least a portion of the TIM that fills the first inner space to the second inner space.

The guide 250 may overlap the shield structure 240 based on a stacking direction of the first PCB, the interposer, and the second PCB.

The guide 250 may include a first part 251 with a longitudinal direction corresponding to a first direction, and a second part 252 with a longitudinal direction corresponding to a second direction intersecting with the first direction.

The first part 251 may guide a portion of the TIM flowing in the second direction in the first inner space to the second inner space.

The second part 252 may guide a portion of the TIM flowing in the first direction in the first inner space to the second inner space.

The guide 250 may include an elastic material and be provided in a state of being compressed by the first PCB and the second PCB.

The guide 250 may be provided in a state of contacting the second PCB.

The PCB structure may further include a first component 260 disposed on the first PCB, and a second component 270 disposed on the first PCB and provided at a position spaced apart from the first component, wherein the first component 260 and the second component 270 may be positioned on opposite sides based on the guide.

The first component 260 may be positioned in an area between the nozzle hole and the guide in the first inner space.

The first component 260 may be positioned in an area filled with the TIM in the first inner space, and the second component 270 may be positioned in an area not filled with the TIM in the first inner space.

The first component 260 may include a thermal source, and the second component 270 may include one of a crystal or an oscillator.

The second PCB 220 may further include a vent hole formed through the second PCB body and provided at a position spaced apart from the shield structure.

The vent hole 224 may be positioned opposite the nozzle hole based on the guide.

The shield structure 240 may include a shield structure body 241 configured to define the second inner space, and an air hole 242 formed through the shield structure body.

The guide 250 may be provided in a state of contacting the interposer.

A PCB structure for containing a TIM may include a first PCB 210, an interposer 230 connected to the first PCB, a second PCB 220 which includes a second PCB body 221 connected to the interposer, a nozzle hole 222 formed through the second PCB body, and a guide hole 223 formed through the second PCB body and provided at a position spaced apart from the nozzle hole and which is configured to define a first inner space S1 together with the first PCB and the interposer, a shield structure 240 connected to the second PCB and configured to contain the TIM passing through the guide hole and define a second inner space S2 connected through the guide hole to the first inner space, and a guide 250 disposed on the first PCB and configured to guide at least a portion of the TIM that fills the first inner space to the second inner space.

The guide 250 may overlap the shield structure 240 based on a stacking direction of the first PCB, the interposer, and the second PCB.

The guide 250 may include an elastic material and be provided in a state of being compressed by the first PCB and the second PCB.

The guide 250 may be provided in a state of contacting the interposer.

In the case of an electronic device including a PCB structure for containing a TIM, the PCB structure 200 may include a first PCB 210, an interposer 230 connected to the first PCB, a second PCB 220 which includes a second PCB body 221 connected to the interposer, a nozzle hole 222 formed through the second PCB body, a guide hole 223 formed through the second PCB body and provided at a position spaced apart from the nozzle hole, and a vent hole 224 formed through the second PCB body and which is configured to define a first inner space S1 together with the first PCB and the interposer, a shield structure 240 connected to the second PCB and configured to contain the TIM passing through the guide hole and define a second inner space S2 connected through the guide hole to the first inner space, and a guide 250 disposed on the first PCB, configured to guide at least a portion of the TIM that fills the first inner space to the second inner space and to overlap the shield structure based on a stacking direction of the first PCB, the interposer, and the second PCB, and provided in a state of contacting the second PCB, wherein the vent hole 224 may be positioned opposite the nozzle hole 222 based on the guide 250.

The effects of the electronic device according to embodiments are not limited to the above-mentioned effects, and other unmentioned effects can be clearly understood from the following description by one of ordinary skill in the art.

The embodiments of the present disclosure are intended to be illustrative and not restrictive. Any of the embodiment(s) described herein may be used in combination with any other embodiment(s) described herein.

## Claims

1. An electronic device comprising:
a first printed circuit board, "PCB", (210);
a second PCB (220);
a shield structure (240) surrounding a component disposed on the second PCB (220); and
an interposer (230) connected between the first PCB and the second PCB,
wherein the second PCB comprises a nozzle hole (222) formed through the second PCB, and a guide hole (223) formed through the second PCB and provided at a position spaced apart from the nozzle hole,
wherein the nozzle hole is configured to allow a thermal interface material, "TIM", to be injected therethrough to fill at least a portion of a first inner space (S1) defined by the first PCB, the second PCB, and the interposer, and
at least a portion of a second inner space (S2) defined by the shield structure and the second PCB is configured to be filled by the TIM passing through the guide hole from the first inner space.

2. The electronic device of claim 1, further comprising:
a guide (250) configured to guide a portion of the TIM in the first inner space so that the TIM passes through the guide hole and moves to the second inner space when the TIM is injected through the nozzle hole.

3. The electronic device of claim 2, wherein the guide comprises:
a first part (251) with a longitudinal direction corresponding to a first direction; and
a second part (252) with a longitudinal direction corresponding to a second direction intersecting with the first direction.

4. The electronic device of claim 2 or 3, wherein the guide is disposed in the vicinity of the guide hole.

5. The electronic device of any one of claims 2 to 4, wherein the guide contacts the interposer.

6. The electronic device of any one of claims 2 to 5, wherein the guide comprises an elastic material and is compressed by the first PCB and the second PCB.

7. The electronic device of any one of claims 2 to 6, wherein the guide contacts the second PCB.

8. The electronic device of any one of claims 2 to 7, further comprising:
a first component (260) disposed on the first PCB; and
a second component (270) disposed on the first PCB and provided at a position spaced apart from the first component,
wherein the first component and the second component are positioned on opposite sides of the guide, and the guide is configured to prevent the TIM from flowing to the second component.

9. The electronic device of claim 8, wherein the first component is positioned in an area between the nozzle hole and the guide in the first inner space.

10. The electronic device of claim 8 or 9, wherein
the first component is positioned in an area that is configured to be filled with the TIM in the first inner space, and
the second component is positioned in an area that is configured not to be filled with the TIM in the first inner space.

11. The electronic device of any one of claims 8 to 10, wherein the first component comprises a thermal source.

12. The electronic device of any one of claims 8 to 11, wherein the second component comprises at least one of a crystal or an oscillator.

13. The electronic device of any one of claims 1 to 12, wherein the second PCB 220 further comprises a vent hole (224) formed through the second PCB and provided at a position spaced apart from the shield structure.

14. The electronic device of claim 13, wherein the vent hole and the nozzle hole are positioned on opposite sides of the guide.

15. The electronic device of any one of claims 1 to 14, wherein the shield structure comprises an air hole (242) formed through the shield structure.
